Europäisches Patentamt

European Patent Office

Office européen des brevets

(11) Publication number: **0 451 587 A2**

# EUROPEAN PATENT APPLICATION

(21) Application number: 91104613.4

(22) Date of filing: 24.03.91

(51) Int. Cl.5: **C23C 14/32**, H01J 37/32

(30) Priority: 28.03.90 IT 4780090

(43) Date of publication of application:
16.10.91 Bulletin 91/42

(84) Designated Contracting States:
**DE FR GB NL SE**

(71) Applicant: SELENIA INDUSTRIE
ELETTRONICHE ASSOCIATE S.p.A.
Via Tiburtina, KM 12.400
I-00131 Roma(IT)

(72) Inventor: **Varasi, Mauro**
**Via Salvatore Talamo n. 8**
**I-00177 Roma(IT)**
Inventor: **Mancini, Calisto**
**Via Porta S. Martino n. 3**
**I-00036 Palestrina, Roma(IT)**

(74) Representative: **Gustorf, Gerhard, Dipl.-Ing.**
**Patentanwalt Dipl.-Ing. Gerhard Gustorf**
**Bachstrasse 6 A**
**W-8300 Landshut(DE)**

(54) **Method for depositing a thin film on a substrate employing radio frequency excited gaseous plasma.**

(57) Method for the deposition of thin films having high adherence, density, stability, absence of optical scattering and mechanical resistence characteristics.

It belongs to the field of thin film growth techniques (0.01 to 10 microns) for application to optics, integrated optics, microelectronics and metallurgy.

The method consists in the adoption of a system for the deposition under vacuum from a thermal source or electronic cannon and an RF power generator (13.6 MHz Radio Frequency) connected through an impedence adapter network to the substrate carrier which equips the deposition system.

The power of the generator allows to maintain a RF discharge in a gas input to the deposition system at a pressure of 1 10 mtorr.

Having a suitable condenser in series with the adapting network and the substrate carrier, it is in negative auto bias situation equal to about 45-48 % of the peak to peak RF discharge. This condition is imposed by the minor mobility of the ions compared to that of the plasma electrons and therefore also by the average electrical charge equal to zero on the electrodes of the RF discharge. In this situation the substrate resting on the substrate carrier is bombarded by the ions generated during the discharge and it simultaneously condenses the material evaporated by the thermal source or by the electron cannon.

This simultaneous bombardment at energies variable between 100 and 400 electron volts provides considerable improvements in the optical and mechanical characteristics of the films deposited.

FIG. 1

The invention regards a new method for the deposition of thin films for optics, integrated optics, microelectronics and metallurgy applications.

The invention belongs to the field of deposition of thin films in vacuum starting from the vapour phase with the assistance of ionic bombardment.

In the vast spectrum pf thin film applications, dielectric or metal, grown through phisical deposition techniques starting from vacuum vapour phase (PVD-Phisical Vapor Deposition), many and various are the parameters which from time to time become significant for the performance required. However, the simultaneous optimization of these parameters may be considered essential in the greater part of applications. Among these parameters, the most important are the following:

- adherence of the film to the substrate and between film and film;
- structural homogeneity of the film;
- high density;
- correct composition;
- absence of internal or interface tensions;
- high mechanical resistance.

Meeting such requirements is dependant upon the energy distribution of the material which condenses forming the film or which in general has an impact on the surface of the growing film.

The evolution of the PVD deposition technologies, from thermal souce evaporation to evaporation from electronic gun, and then to DC or RF plasma sputtering, reaching ion gun sputtering, can be schematically represented by a progressive increase of the average kinetic energy of the condensing material. Technology has evolved from 0.01 to 0.1 eV of thermal evaporation to 10 to 20 eV of the ion gun sputtering.

The most important reasons for this relationship between film characteristics and kinetic energy of the material impinging on the film during its growth are the following:

- greater residual post absorption stability, with consequential possibility of researching more stable condensation sites;
- re-sputtering of the elements weackly connected.

However,the historical progress of these technologies is associated with an exponential growth of the cost of the equipment and of their maintenance and an equally significant drop of productivity. One same film deposited by ion gun sputtering requires on average a process time of one order of magnitude that required for plasma sputtering and in this case the process lasts more than one or two orders of magnitude that required by an evaporation system.

It becomes therefore quite clear that to have available a technology which can associate the advantages of an ideal energy content with the productivity, reliability and testability advantages of the evaporation techniques of a thermal source or electron gun.

Attempts to achieve this goal have been made using ion guns in a n electron gun evaporation system.

The ions, produced at medium energy (from a few tens to a few hundreds of eV) by the ion gun, bombarding the film during its growth. However in this configuration two significant drawbacks exist: the high cost and the impossibility to transform the condensing material originated by the electron gun into kinetic energy vectors.

An other configuration which has been proposed is based upon the concentration of an electron flow at low energy levels (10-100 eV) and high current (10-100 Ampere) close to the source to be evaporated, where the probability of ionizing it is greatest.

With these configurations it is possible to obtain ionization percentages up to 50 or 60 %. The ions so generated are then accelerated towards the substrate where they condense together with the material which did not play any role. However this technique is extremely costly and complex and it causes inconveniences when the material to be deposited is a dielectric.

The invention described in this inventiuon application overcomes these limitations, obtaining the advantages due to the increased average value of the kinetic energy of the material impinging on the film surface during its growth: allowing the deposition of dielectric films; achieving a reliable, testable and highly productive process.

The method dealt with by this invention is characterized by:

- the utilization of a conventional vacuum system for the deposition of thin films from thermal souce or electron gun with a substrate carrier electrocally isolated towards ground;
- the use of an RF power generator electrically adapted to the substrate carrier and capable of producing power densities to the substrate carrier up to 0.1 Watt/cm@;
- the use of a gas, with a pressure in the region of 1 to 10 mtorr, partially ionized by an RF discharge maintained betwen the substrate carrier and the vacuum bell;
- the use of a condenser in series with the substrate carrier and the adapting network towards the RF generator, which provides for the negative self bias of the substrate carrier due to the less mobility of the plasma ions compared to that of electrons;
- the self bias substrate carrier value between 100 and 400 V controllable through the variable ratio between the areas of the substrate carrier and that of the discharge anode, as well as by the RF power provided by the generator and the nature and pressure of the gas which carries the discharge;

- the possibility to deposit on non preheated substrates or at least at low temperatures;
- the possibility to deposit on dielectric substrates
- the possibility to obtain great thickness uniformity even in non planar surface cases;
- the possibility to deposit on surfaces which are not in direct view of the source of evaporating material;
- the high adhesion between film and substrate and between film and film;
- the low interface and internal tension films obtainable;
- low scattering optical films obtainable.

The invention will now be described with reference to the figures attached with illustrative but nion limiting purposes.

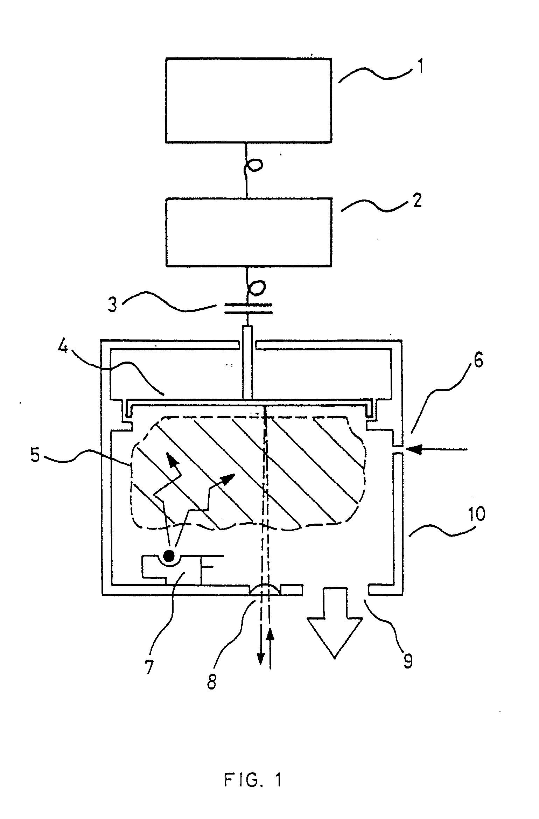

Figure 1 Schematic of the equipment for the deposition of thin films where we can see:

1 Radio frequency generator;
2 Matching network;
3 Blocking condenser;
4 Rotating substrate carrier cathode;
5 Partially ionized gas (plasma);
6 Gas input;
7 Electron gun;
8 Optical system operating by reflection for the film thickness control;
9 Access to the vacuum pumps;
10 Bell.

Figure 2 Time variation of the cathode voltage of the RF discharge where we can see:

11 The positive bias period;
12 The negative bias period;
13 The self bias voltage.

The essential characteristics of the deposition method presented and presently preferred by the inventor can be described as follows, with illustrative but non limiting purposes: The substrates onto which the films have to be deposited are fixed to the substrate carrier 4 within the vacuum bell 10. The substrate carrier is electrically isolated from ground and is in contact with the RF generator 1 through the blocking condenser 3 and the impedance matching network 2.

The material to be deposited is positioned in the chamber of electron gun 7.

The vacuum system is closed and emptied till residual pressure less than 1 microtorr is achieved through access 9 to the vacuum pumps. Then, through access 6 the gas that must bear the RF discharge is input to the system till a pressure of 1 to 10 mtorr is achieved.

The RF discharge is then triggered for 5 to 10 minutes to allow ion cleaning of the substrate surfaces, with cathode power density variable between 0.01 and 0.1 Watt/cm2.

At the end of such cleaning period, the electron gun 7 is activated and then evaporation and deposition start so that the RF discharge does not stop.

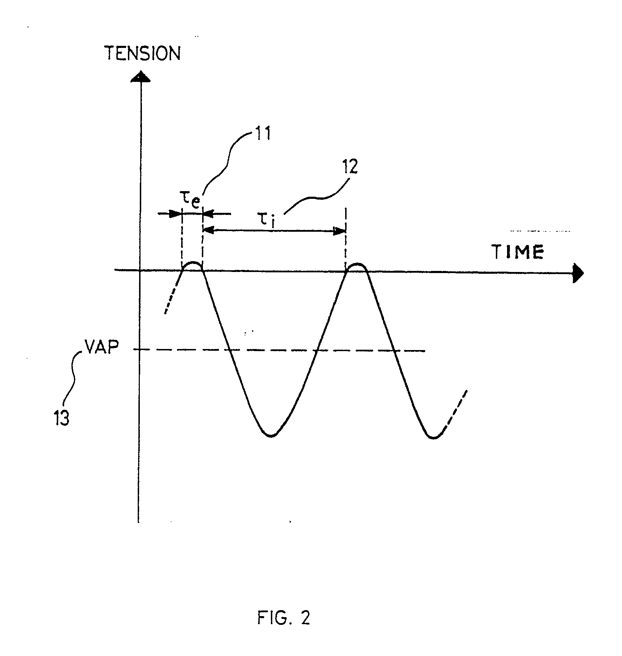

The voltage difference between discharge cathode (the substrate carrier) and plasma 5 varies in time as shown in figure 2. It varies periodically according to the variation imposed by the RF generator and is positive and negative for times Te 11 and Ti 12 when electrons and ions are collected on the electrode by the plasma. As the electron mobility (Me) and of the ions (Mi) in the plasma are quite different and in order to satisfy the cathode average null voltage, we have that Te is far less than Ti, resulting in an auto bias of cathode substrate carrier 13.

The value of this self bias voltage depends on the nature and pressure of the gas maintaining the discharge, on the power generated by the RF generator and by the ratio of cathode and anode areas which limit the plasma.

Typical values used for Vap vary in the range 100 to 400 V.

The use of lower Vaps is less effective as the ratio between energy carriers and low energy material impinging on the growing film surface is less than 10% and the kinetic energy contribution is therefore low.

Vap values higher than 500-600 volts is damaging as the release of kinetic energy by accelerated ions can take place at subsurface level causing damage within the film which result in a density reduction.

The evaporated material by the electron gun enters the gas which bears the dischrge and undergoes two significant types of interaction:

- collisions with gas neuters or ions;
- ionization by collision with electrons or ions.

The collisions which result in ionization have two consequences, random trajectory and medium to low kinetic energy level. The diffusion of evaporated material by collision with the gas provide better uniformity even on substrates with irregular surfaces, and also the deposition on surfaces which are not in direct view of the material source.

The ionization of the evaporated material, which can reach 5-10 % of the deposited material, transfers kinematic energy directly to the material which then condensing forms the film, with great advantages to the film itself.

The photometric reflection system 8 ensures the possibility of real time control of the growing film, the uniformity of which is ensured also by the rotation of the substrate carrier.

## Claims

1. Method for the deposition of thin films, characterized by the fact of using a conventional vacuum deposition system from a thermal source or electron gun,an RF plasma at pressures of the order of 1 to 10 m Torr as souce of ions at medium energy (100-400 eV) to assist in terms of energy the growth of the thin film positioned on a substrate carrier (4) set within the bell and in electrical contact with the RF generator (1) through the blocking condenser (3) and the impedance matching network (2).

2. Method for the deposition of thin films as per claim 1 where it is possible to deposit thin films on non pre heated or intentionally cooled surfaces .

$. Method for the deposition of thin films as per claim 1, characterized by the fact that it can be applied to the many sectors of optics, integrated optics, microelectronics and metallurgy.

FIG. 1

FIG. 2